# EUROPÄISCHE PATENTSCHRIFT

(11) **EP 0 301 283 B1**
(45) Veröffentlichungstag und Bekanntmachung des Hinweises auf die Patenterteilung: **01.12.1993**
(21) Anmeldenummer: 88110769.2
(22) Anmeldetag: 06.07.1988
(51) Int. Cl.: H01L 39/14, H01L 39/24, C04B 35/00, H01B 12/00

(54) **Verfahren zur Herstellung eines ummantelten Drahtes aus einem keramischen Hochtemperatur-Supraleiter**
Process for producing a coated ceramic high-temperature superconductor wire
Procédé de fabrication d'un fil enrobé en céramique supraconductrice à haute température

(30) Priorität: 24.07.1987 CH 2818/87; 30.10.1987 CH 4263/87; 14.01.1988 CH 113/88
(43) Veröffentlichungstag der Anmeldung: 01.02.1989
(73) Patentinhaber: ASEA BROWN BOVERI AG, 5400 Baden (CH)
(72) Erfinder: Meyer, Gundolf, Dr., CH-5413 Birmenstorf (CH); Schönfeld, Erwin, CH-5405 Baden-Dättwil (CH); Verpoort, Clemens, Dr., CH-5442 Fislisbach (CH)

(56) Entgegenhaltungen:
- EP-A- 0 087 691
- ADVANCED CERAMIC MATERIALS, Band 2, Nr. 3B, Juli 1987, Seiten 388-400, ACerS, Westerville, OH, US; R.W. McCALLUM et al.: "Problems in the production of YBa2Cu3Ox superconducting wire"
- APPLIED PHYSICS LETTERS, Band 51, Nr. 3, 20. Juli 1987, Seiten 203,204, American Institute of Physics, New York, US; S. JIN et al.: "High Tc superconductors - composite wire fabrication"
- ADVANCED CERAMIC MATERIALS- CERAMIC SUPERCONDUCTORS, Band 2, Nr. 3B, Juli 1987, Seiten 471-479, ACers, Westerville, OH, US; W.J. WEBER et al.: "Synthesis and characterization of YBa2Cu3O7-x superconductors"
- ZEITSCHRIFT FÜR PHYSIK B - CONDENSED MATTER, Band 66, 1987, Seiten 141-146, Springer Verlag; C POLITIS et al.: "Superconductivity at 40 K in La1.8Sr0.2CuO4"
- COMMISSION OF EUROPEAN COMMUNITY, EUROPEAN WORKSHOP ON HIGH Tc SUPERCONDUCTOR AND POTENTIAL APPLICATIONS, PROCEEDINGS ITALIA, 1.-3. Juli 1987, Seiten 133-135; P. DUBOTS et al.: "First characterizations of high Tc superconducting oxide based multifilamentary wires"
- ADVANCED CERAMIC MATERIALS- CERAMIC SUPERCONDUCTORS, Band 2, Nr. 3B, Juli 1987, Seiten 530-538, ACerS, Westerville, OH, US; C.K. CHIANG et al.: "Low temperature thermal processing of Ba2YCu3O7-x superconducting ceramics"

## Beschreibung

### Technisches Gebiet

Technologie der elektrischen Supraleiter. In neuester Zeit nimmt die Bedeutung von Werkstoffen, welche supraleitende Eigenschaften haben, mehr und mehr zu. Die Entdeckung von neuen supraleitenden Werkstoffen, insbesondere des Typs Seltene Erden/Ba/Cu/O, führte zu einer beträchtlichen Erweiterung der Anwendungsmöglichkeiten für Supraleiter, da diese Stoffe bereits bei Temperaturen oberhalb 50K supraleitend werden.

Die Erfindung bezieht sich auf die Weiterentwicklung und Verbesserung von Bauteilen aus einem keramischen Hochtemperatur-Supraleiter in Drahtform, wobei den Bedürfnissen der industriellen Grossproduktion Rechnung getragen werden soll.

Insbesondere betrifft sie ein Verfahren zur Herstellung eines ummantelten Drahtes oder eines Mehrfach-Filamentleiters aus einem keramischen Hochtemperatur-Supraleiter auf der Basis eines keramischen Stoffes des Typs SEBa₂Cu₃O_{6,5 + y}, wobei SE ein seltenes Erdmetall bedeutet und y gemäß 0<y<1 auf Werte zwischen 0 und 1 beschränkt ist. Der besagte Stoff ist als Kern in einem als mechanischer Träger und Notstromleiter dienenden Kupfermantel angeordnet, in welchem die in einem annähernd stöchiometrischen Verhältnis gemischten pulverförmigen Ausgangsstoffe seltenes Erdmetalloxid, Barium-Sauerstoff-Verbindung und Kupferoxid CuO oder das fertige Supraleiterpulver in ein Metallrohr abgefüllt und das Ganze zur Formgebung einem Warm- und/oder Kaltverformungsprozess durch Pressen, Walzen Rundhämmern und ziehen unterworfen und anschliessend einer Wärmebehandlung unterzogen wird.

### Stand der Technik

Mit dem Oberbegriff der Patentansprüche 1 und 2 nimmt die Erfindung auf einen Stand der Technik Bezug, wie er aus Advanced Ceramic Materials-Ceramic Superconductors 2 (1987), 20. 7. 87, No. 3B, Westerville, OH, USA, S. 388 - 400, R. W. McCallum et al., bekannt ist. Dort wird aus pulverförmigen Oxiden von Y₂O₃, CuO und BaCO₃ supraleitendes Material der Zusammensetzung YBa₂Cu₃Oₓ hergestellt. Dieses Material wird zur Herstellung von Supraleiterdrähten als Pulver in das Innere eines Metallrohres gebracht. Dann wird dieses Metallrohr mechanisch reduziert und anschliessend während 36 h einer Temperatur von 890 °C ausgesetzt. Das so erhaltene Material wird gemahlen und während 2,5 d in reiner O₂-Atmosphäre in einem Temperaturbereich von 950 °C - 960 °C gehalten. Anschliessend wurde das Material 4 h bei 700 °C geglüht und dann im Ofen bis 200 °C abgekühlt. Optimale Werte für x liegen im Bereich von 6,8 - 6,9, die durch ein abschliessendes Glühen bei 600 °C - 700 °C in Sauerstoffatmosphäre erreicht wurden. Silberoxid kann dem YBa₂Cu₃Oₓ-Kern zugefügt werden, das unterhalb 500 °C in Ag + O₂ zerfällt und als innere O₂-Quelle dient, wobei das Rohr nicht aus Silber bestehen muss. Zwischen Rohr und Kern ist eine Metallbarriere vorgesehen.

In Appl. Phys. Lett. 51 (3), 20. 7. 87, S. 203 und 204, S. Jin et al., ist ein Verfahren zur Herstellung eines Supraleiterdrahtes und von Mehrfach-Filamentleitern angegeben, bei dem innerhalb eines gutleitenden Metallmantels aus Ag oder aus Cu mit einer Ni/Au-Diffusionssperre ein supraleitender Kern aus Ba₂YCu₃O₇ vorgesehen ist. Der zu einer Spule gewickelte Draht mit Ba₂YCu₃O₇-Pulver erhält nach einer 8stündigen Hitzebehandlung bei 900 °C - 950 °C, bei welcher Sauerstoff entweicht, und nachfolgender 4stündiger Sinterung bei 600 °C in Sauerstoffatmosphäre die gewünschte chemische Zusammensetzung und eine dichte Struktur. Dünne Silberrohre und -schichten eignen sich besonders gut zur Herstellung, da sich die Oxide Ag₂O oder Ag₂O₂ bilden, welche als Sauerstoffdonatoren für den Kern geeignet sind.

Ferner ist es bekannt, Supraleiter des Typs SEBa₂Cu₃O_{6,5-7} durch Bereitstellen und Mischen von Pulvern der Ausgangsmaterialien und anschliessender Wärmebehandlung herzustellen. Als Ausgangsmaterialien werden in der Regel Y₂O₃/CuO und BaO oder BaCO₃ verwendet. Im Falle von BaCO₃ muss das CO₂ durch einen zusätzlichen Kalzinierungsprozess ausgetrieben werden, vgl. T. Kawai and M. Kanai, "Preparation of High-T_{c} Y-Ba-Cu-O Superconductor", Japanese Journal of Applied Physics, Vol 26, No. 5, May 1987, S. L736 - L737; Y. Yamada, N. Fukushima, S. Nakayama, H. Yoshino and S. Murase, "Critical Current Density of Wire Type Y-Ba-Cu Oxide Superconductor", Japanese Journal of Applied Physics, Vol 26, No. 5, May 1987, S. L865 - L866. Dabei wird in sauerstoffhaltiger Atmosphäre (Luft) gesintert, also unter einem gewissen O₂-Partialdruck. Dadurch steuert die umgebende Sinteratmosphäre ihren Beitrag zur Erreichung eines leicht überstöchiometrischen Sauerstoffgehalts der Verbindung bei. Es ist auch schon vorgeschlagen worden, den Sinterprozess in einem Silberröhrchen durchzuführen. Silber ist für elementaren Sauerstoff durchlässig, so dass letzterer durch Diffusion in das Kernmaterial hineingelangt, vgl. European Materials Research Society Meeting, Council of Europe, Strasbourg, June 3, 1987, SUPERCONDUCTING MATERIALS WITH HIGH TRANSITION TEMPERATURES, Session C, Bericht 22, H. Yoshino, N. Fukushima, H. Niu, S. Nakayama, Y. Yamada and S. Murase, "Superconducting Wire and Coil with Zero Resistance State at 90 K and Current Density of 510 A/cm² at 77 K", Toshiba Corporation, R & D Center, Sawai-ku, Kawasaki-city 210, Japan.

Versucht man das Silberröhrchen durch ein Kupferröhrchen zu ersetzen, so führt dies zu einem Misserfolg. Bei einer Sintertemperatur von 700 °C und mehr reagiert das Kupfer mit der supraleitenden Verbindung und entzieht dieser Sauerstoff. Danach wird die innere Struktur derselben derart verändert, dass sie ihre supraleitenden Eigenschaften verliert. Ausserdem ist Kupfer für elementaren Sauerstoff nicht durchlässig, sodass das obige verfahren nicht auf Kupfer übertragbar ist. Eine äussere Anwendung eines hohen O₂-Partialdruckes wäre ohne jeden Erfolg.

Es besteht daher ein grosses Bedürfnis, Wege zu finden und verfahren vorzuschlagen, die die obigen Unzulänglichkeiten nicht aufweisen.

### Darstellung der Erfindung

Die Erfindung, wie sie in den Patentansprüchen 1 und 2 definiert ist, löst die Aufgabe, ein Verfahren zur Herstellung eines ummantelten keramischen Hochtemperatur-Supraleiters auf der Basis einer seltenen Erde/Barium/Kupfer/Sauerstoff-Verbindung in Drahtform vorzuschlagen, welches in seiner Durchführung einfach und kostengünstig ist und für das supraleitende Kernmaterial die Bereitstellung des für die Supraleitung notwendigen Sauerstoffüberschusses während der Herstellungs- und Betriebszeit gewährleistet.

### Weg zur Ausführung der Erfindung

Die Erfindung wird anhand der nachfolgenden, durch Figuren näher erläuterten Ausführungsbeispiele beschrieben.

Dabei zeigt:
- Fig. 1: einen schematischen Querschnitt durch einen Draht vor der Wärmebehandlung,
- Fig. 2: einen schematischen Querschnitt durch einen supraleitenden Draht nach der Wärmebehandlung,
- Fig. 3: einen schematischen Querschnitt durch einen Draht mit CuO-Schicht vor der Wärmebehandlung,
- Fig. 4: einen schematischen Querschnitt durch einen Draht mit Diffusionsbarriere vor der Wärmebehandlung,
- Fig. 5: einen schematischen Querschnitt durch einen Draht mit einer Schicht mit Sauerstoff-Reserve vor der Wärmebehandlung,
- Fig. 6: ein Flussdiagramm des Verfahrensablaufes nach einer Variante I,
- Fig. 7: einen schematischen Querschnitt durch einen Mehrfach-Filamentleiter mit Sauerstoff-Reserve,
- Fig. 8: ein Flussdiagramm des Verfahrensablaufes nach einer Variante II.

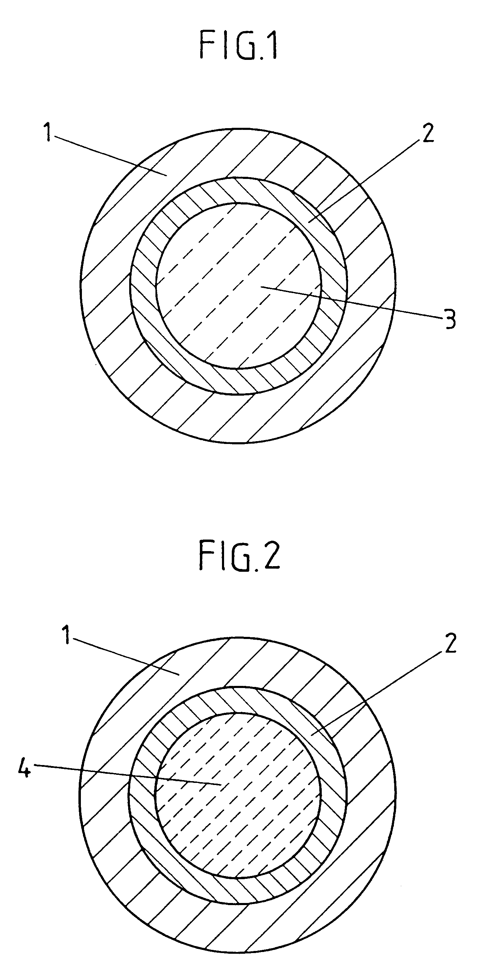

In Fig. 1 ist ein schematischer Querschnitt durch einen Draht im Zustand dar Endform, d.h. nach dem Walzen, Rundhämmern, Ziehen etc., jedoch vor der Wärmebehandlung dargestellt. 1 ist ein Metallmantel (Kupferrohr), der als mechanischer Träger zur Wahrung der geometrischen Form und als elektrischer Notstromleiter dient. 2 ist eine Zwischenschicht aus Silber in Form eines Rohres oder galvanischen oder anderen Ueberzuges. 3 ist die aus den Ausgangsmaterialien in Pulverform (Partikelgrösse ca. 1 bis 50 µm) bestehende Mischung: Y₂O₃/BaO/BaO₂/CuO. Das Mischungsverhältnis ist so eingestellt, dass gegenüber der stöchiometrischen Verbindung ein Sauerstoffüberschuss vorhanden ist. Darin sind ausserdem die während der Herstellung zu erwartenden Sauerstoffverluste mit berücksichtigt. Dadurch wird erreicht, dass trotz dem unvermeidbar aus dem Kern herausdiffundierenden Sauerstoff ein zur Bildung einer optimalen Supraleiterverbindung ausreichender Sauerstoffvorrat im Kern vorhanden ist.

Fig. 2 stellt einen schematischen Querschnitt durch einen supraleitenden Draht nach der Wärmebehandlung (Reaktion der Ausgangsmaterialien, Sintern des Kerns) dar. 1 ist der Metallmantel, 2 die Zwischenschicht aus Silber. 4 ist der Kern aus fertiger supraleitender Keramik, z.B: aus YBa₂Cu₃O_{6,5-7,5.}

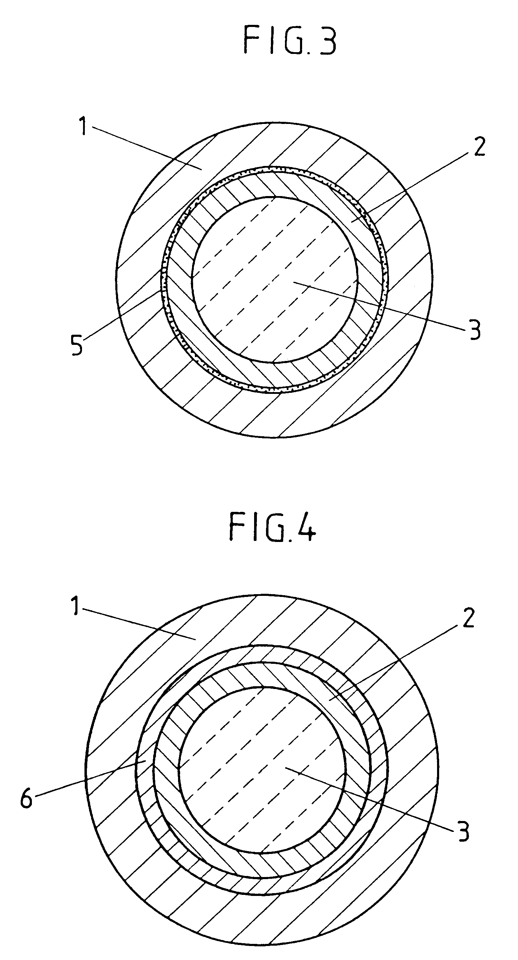

In Fig. 3 ist ein schematischer Schnitt quer durch einen Draht mit einer CuO-Schicht vor der Wärmebehandlung dargestellt. 1 ist der Metallmantel, im vorliegenden Fall aus Kupfer, der an seiner Innenfläche oxydiert ist. Die Schicht 5 aus Kupferoxid CuO hat eine Dicke von ca. 1 bis 100 µm. Durch diese Schicht 5 wird eine weitere Oxydation des Mantels 1 von innen heraus und eine Verarmung des Kernmaterials an Sauerstoff erschwert. Das CuO wirkt wie eine lokale Erhöhung des Sauerstoffpartialdruckes. 3 ist die Pulvermischung aus Y₂O₃/BaO/BaO₂/CuO vor der Wärmebehandlung.

Fig. 4 zeigt einen schematischen Querschnitt durch einen Draht mit einer Diffusionssperre vor der Wärmebehandlung. Die Bezugszeichen 1,2 und 3 und deren Bedeutung entsprechen genau denjenigen der Fig. 1. 6 ist eine Diffusionssperre aus Tantal, Niob, Vanadium oder Nickel, welche die Abwanderung des Sauerstoffs aus dem Kernmaterial weitgehend unterbindet. Die Diffusionssperre 6 kann statt aus einem der vorgenannten Stoffe auch aus einer Legierung mindestens zweier dieser Elemente bestehen.

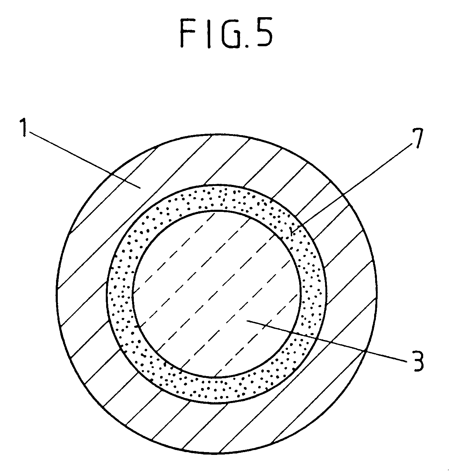

Fig. 5 stellt einen schematischen Querschnitt durch einen Draht mit einer Schicht mit Sauerstoff-Reserve vor der Wärmebehandlung dar. 1 ist der Metallmantel, 3 die Pulvermischung aus Y₂O₃/BaO/BaO₂/CuO und 7 eine Zwischenschicht aus Silber, welche mit Silberoxid AgO oder mit Bariumperoxyd BaO₂ dotiert ist. Die Funktion dieser Oxide ist ähnlich wie diejenige des CuO in Fig. 3.

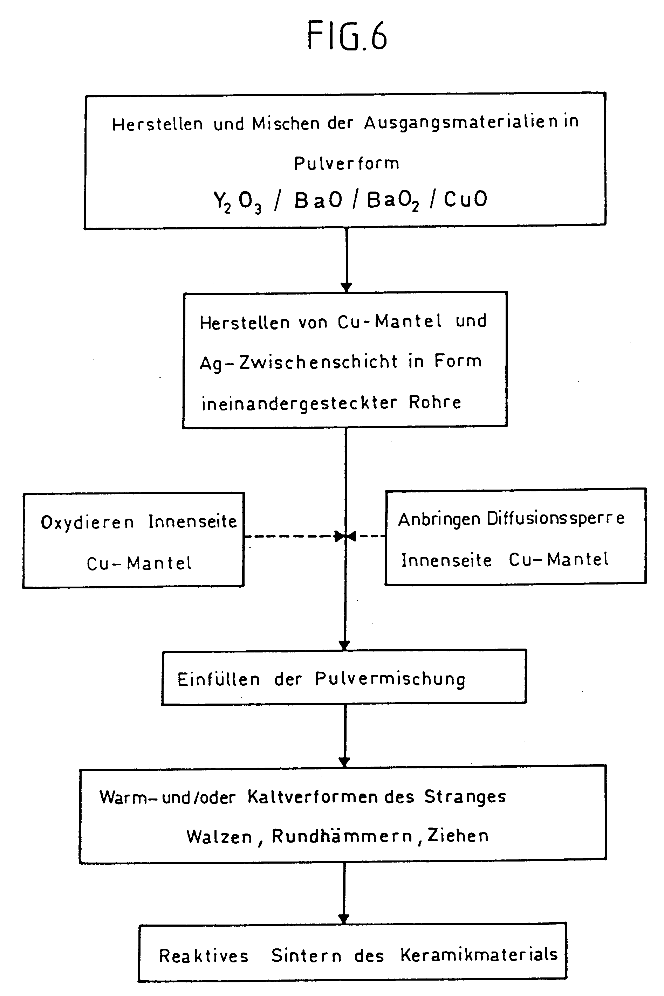

Fig. 6 bezieht sich auf ein Flussdiagramm des Verfahrensablaufs nach Variante I. Das Diagramm erklärt sich von selbst. Als Untervarianten zu den unumgänglichen Verfahrensschritten sind alternativ
"Oxydieren Innenseite Cu-Mantel" oder
"Anbringen Diffusionssperre Innenseite Cu-Mantel"
eingezeichnet (durch gestrichelte Linien angedeutet).

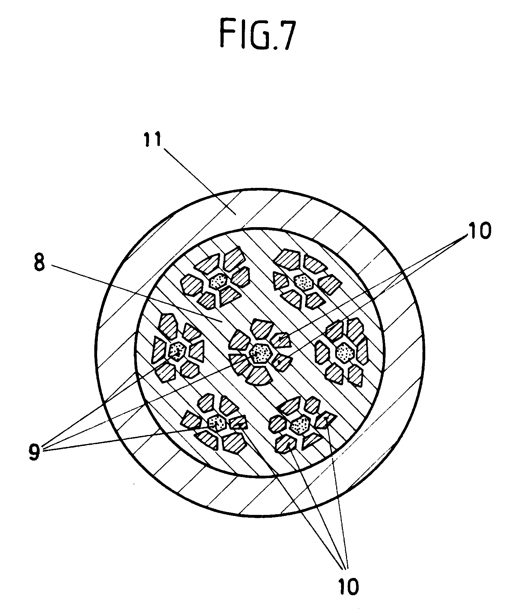

In Fig. 7 ist ein schematischer Querschnitt durch einen Mehrfach-Filamentleiter mit Sauerstoff-Reserve dargestellt. In einem von einer Nickelhülle 11 als mechanische Stütze und als Korrossionsschutz allseitig umschlossenen, als Gerüst und als Notstromleiter dienenden Silberkörper 8 ist eine Vielzahl von Filamenten eingebettet. Es sind mehrere Gruppen von Löchern vorhanden, wobei pro Gruppe je ein zentrales und eine Reihe von peripheren Löchern vorhanden sind. 9 ist ein zentrales, mit einer sauerstoffabgebenden Substanz (z.B. BaO₂) gefülltes Loch. 10 ist ein peripheres, mit dem fertigen Supraleiterpulver (z.B. YBa₂Cu₃O₇) gefülltes Loch. Durch die bei der Verformung (Formgebung) erlittene Querschnittsverminderung nehmen die im ursprünglichen Silberblock runden Löcher im allgemeinen polygonale Querschnitte an.

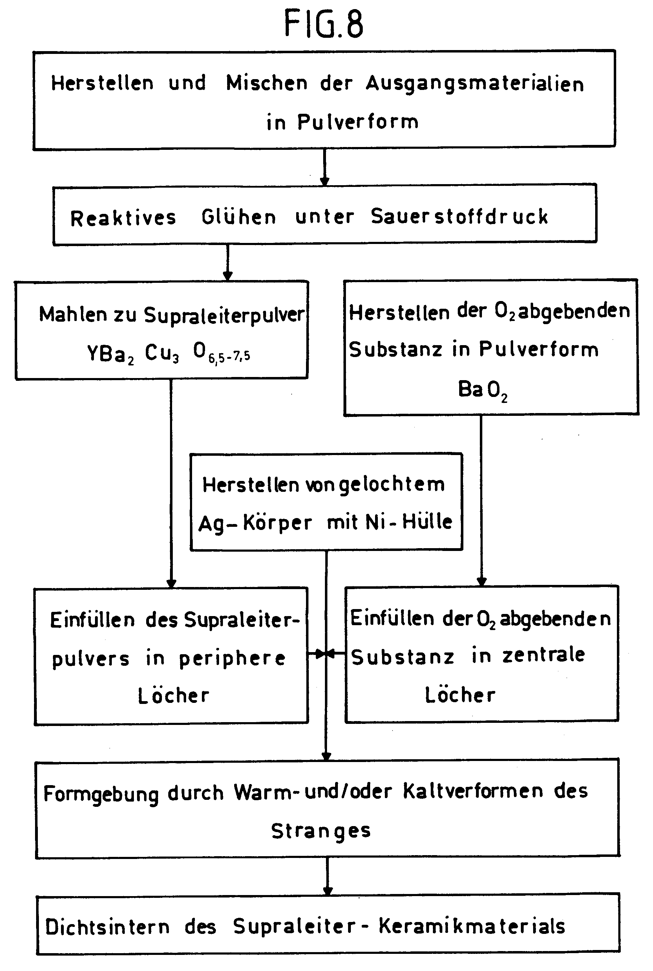

Fig. 8 bezieht sich auf ein Flussdiagramm des Verfahrensablaufes nach Variante II. Diese Variante ist besonders bei der Herstellung von Mehrfach-Filamentleitern gemäss Fig. 7 anzuwenden. Das Diagramm erklärt sich von selbst.

### Ausführungsbeispiel 1:

### Siehe Figuren 1 und 2!

Als Metallmantel 1 wurde ein Kupferrohr von 15 mm Aussen- und 10 mm Innendurchmesser (Wandstärke 2,5 mm) verwendet. Die Zwischenschicht 2 aus Silber wurde durch ein Silberrohr von 10 mm Aussen- und 9 mm Innendurchmesser (Wandstärke 0,5 mm) gebildet. Die Toleranzen der Rohre waren so bemessen, dass sich das Silberrohr gerade stramm sitzend in das Kupferrohr stecken liess. Als Ausgangsmaterialien für den Kern wurden Yttriumoxid Y₂O₃, Bariumperoxid BaO₂ und Kupferoxid CuO verwendet. Das Mengenverhältnis der Stoffe ergab sich nach folgendem Schema:

| | |
|---|---|
| 1 Mol | Y₂O₃ |
| 4 Mol | BaO₂ |
| 6 Mol | CuO. |

Unter der Voraussetzung einer nachfolgenden verlustlosen chemischen Reaktion würde dies einer Verbindung der Formel

YBa₂Cu₃O_{8,5}

entsprechen.

Die Ausgangsstoffe wurden gemischt und in einem Achatmörser zu einem Pulver mit einer Partikelgrösse von weniger als 10 µm zerrieben. Dann wurde die Pulvermischung 3 in das zusammengesetzte Rohr abgefüllt und festgestampft. Hierauf wurden die Enden des Rohres 1 verschlossen. Nun wurde der Außendurchmesser des Rohres 1 durch mehrere Kaltverformungsschritte auf einen Wert von 10 mm reduziert. Diese Formgebung erfolgte durch Rundhämmern. Hierauf wurde das Rohr 1 zu einem Draht mit einem Enddurchmesser von 0,5 mm heruntergezogen. Der Draht wurde nun unter Zwischenschaltung eines Quarzfasergewebes zwischen je zwei Windungen auf einen Spulenkörper aufgewickelt. Das Ganze wurde in einen Ofen gebracht und unter Argonatmosphäre und einem Druck von 100 kPa (1 bar) langsam auf die Reaktions- und Sintertemperatur erhitzt. Der Aufheizvorgang auf eine Temperatur von 700 °C dauerte 10 h. Diese Temperatur wurde dann während 50 h gehalten. Dann wurde der gesinterte Körper mit einer Geschwindigkeit von 50 K/h im Ofen auf ca. 200 °C abgekühlt und dann an Luft auf Raumtemperatur erkalten gelassen. In Anbetracht des direkten Kontaktes Cu/Ag ist darauf zu achten, dass die Sintertemperatur den Wert des tiefschmelzenden Eutektikums (779 °C) nicht erreicht.

### Ausführungsbeispiel 2:

### Siehe Fig. 3!

Das als Metallmantel 1 dienende Kupferrohr von 14 mm Aussen- und 9 mm Innendurchmesser wurde zunächst auf seiner Innenseite in einem Sauerstoffstrom bei 600 °C oxydiert. Die Schicht 5 aus Kupferoxid wurde auf eine Dicke von 50 µm eingestellt. Dann wurde ein Silberrohr 2 von 9 mm Aussen- und 8 mm Innendurchmesser (Wandstärke 0,5 mm) eingesetzt. Nun wurde das Ausgangsmaterial gemäss Beispiel 1 eingefüllt. Das an seinen Enden verschlossene, gefüllte Rohr 1 wurde zunächst zwecks Verdichtung der Pulvermischung 3 kalt-isostatisch gepresst. Dann wurde der so entstandene Draht bis auf einen Durchmesser von 0,6 mm heruntergezogen. Nach der Formgebung wurde der Körper gemäss Beispiel 1, jedoch unter einem Druck von 1 MPa (10 bar) einer Wärmebehandlung unterzogen und am Schluss langsam abgekühlt.

### Ausführungsbeispiel 3:

### Siehe Fig. 4!

In einen prismatischen Kupferblock als zusammenhängenden gemeinsamen Metallmantel 1 wurden zahlreiche Löcher mit parallelen Achsen und einem Achsenabstand von 18 mm gebohrt. Die Löcher hatten einen Durchmesser von 12 mm. Nun wurden in diese Löcher Rohre 6 aus Tantal mit einem Aussendurchmesser von 12 mm und einem Innendurchmesser von 11 mm (Wandstärke 0,5 mm) und in diese weitere Rohre 2 aus Silber mit einem Aussendurchmesser von 11 mm und einem Innendurchmesser von 10 mm (Wandstärke 0,5 mm) eingestossen. Dann wurden die mit Rohren bestückten Löcher des Kupferblocks mit einer Pulvermischung 3 des nachfolgenden Mengenverhältnisses gefüllt:

| | |
|---|---|
| 1 Mol | Y₂O₃ |
| 3 Mol | BaO |
| 1 Mol | BaO₂ |
| 6 Mol | CuO |

Dies entspricht einer Verbindung mit der hypothetischen Zusammensetzung

YBa₂Cu₃O₇

Der prismatische Kupferblock wurde nun durch Kaliberwalzen in seinem Querschnitt sukzessive auf etwa 1/10 des ursprünglichen Wertes reduziert, wobei die Löcher noch einen Durchmesser von ca. 3 mm aufwiesen. Dann wurde die auf diese Weise hergestellte Stange nochmals durch Ziehen auf etwa die Hälfte ihres vorherigen Durchmessers reduziert (Verbleibender Lochdurchmesser ca. 1,5 mm). Die Stange wurde nun in eine Anlage zum heissisostatischen Pressen gebracht, welche mit Argon geflutet wurde. Der Druck wurde auf einen Wert von 20 MPa (200 bar) gesteigert und die Stange langsam auf eine Temperatur von 950 °C gebracht. Die Dauer des Ainfheizens betrug ca. 12 h. Dann wurden die Temperatur von 950 °C und der Druck von 200 bar während 5 h gehalten. Die Abkühlung dieses so gebildeten Mehrfilamentleiters wurde mit einer Geschwindigkeit von 20 K/h vorgenommen.

### Ausführungsbeispiel 4:

### Siehe Fig. 5!

Als Mantel 1 wurde ein Kupferrohr von 14 mm Aussen- und 10 mm Innendurchmesser (Wandstärke 2 mm) verwendet. Die Zwischenschicht 7 aus Silber bestand aus einem Rohr von 10 mm Aussen- und 8,5 mm Innendurchmesser (Wandstärke 0,75 mm), welches mit 10 M % BaO₂ dotiert war. Das Rohr war zuvor nach pulvermetallurgischen Methoden (z.B. durch mechanisches Legieren) hergestellt worden. Das dotierte Silberrohr wurde stramm sitzend in das Kupferrohr eingepasst. Als Ausgangsmaterialien für den Kern wurde eine Pulvermischung aus Y₂O₃, BaO₂ und CuO verwendet:

| | |
|---|---|
| 1 Mol | Y₂O₃ |
| 2 Mol | BaO₂ |
| 6 Mol | CuO |

Dieses Pulver wurde während 10 h bei 900 °C vorgesintert und der Sinterkörper erneut gemahlen. Zu diesem Pulver wurden noch 2 Mol BaO₂ zugegeben und das Ganze als Pulvermischung 3 in das zusammengesetzte Rohr eingefüllt und festgestampft. Die Weiterverarbeitung des Stranges erfolgte genau gleich wie unter Beispiel 2 angegeben.

Die mit BaO₂ dotierte Zwischenschicht 7 lässt sich auch durch kombiniertes elektrolytisches/elektrophoretisches Abscheiden aus einem Elektrolyten, in dem BaO₂-Pulver aufgeschlämmt ist, auf der Innenseite des Metallmantels 1 abscheiden. Ferner kann die Zwischenschicht 7 auch durch Oxydation des Silberrohres im Sauerstoffstrom bei Temperaturen um ca. 100 °C herum hergestellt werden.

### Ausführungsbeispiel 5:

### Vergl. Fig. 7!

In eine zylindrische Silberstange 8 von 50 mm Durchmesser als zusammenhängenden gemeinsamen Metallmantel wurden insgesamt 7 achsenparallele Löcher 9 von 12 mm Durchmesser gebohrt. Um ein solches zentrales Loch 9 waren 6 weitere Löcher 10 zentralsymmetrisch angeordnet, so dass deren Achsen ein gleichseitiges Sechseck bildeten. Der Achsenabstand war somit für alle Löcher 10 gleich und betrug 15 mm. Die Silberstange 8 wurde stramm in ein Nickelrohr 11 von 50 mm Innen- und 64 mm Aussendurchmesser (Wandstärke 7 mm) eingepasst. Das Ganze wurde dann axial in ein nicht dargestelltes Kupferrohr als äusserste Hülle eingepasst. Das Kupferrohr hatte einen Innendurchmesser von 64 mm und einen Aussendurchmesser von 80 mm.

Die zentralen Löcher 9 wurden nun mit der sauerstoffabgebenden Substanz in Form von MnO₂-Pulver gefüllt. In die peripheren Löcher 10 wurde Pulver aus einem Hochtemperatur-Supraleiter eingefüllt.

Das Supraleitermaterial hatte die Zusammensetzung

YBa₂Cu₃O₇₊ₓ, mit -0,5 ≦ x ≦ + 0,1,

wobei im vorliegenden Fall x ≈ O betrug. Die Herstellung erfolgte durch Mischen der gemahlenen Komponenten nach dem folgenden Mengenverhältnis:

| | |
|---|---|
| 1 Mol | Y₂O₃ |
| 2 Mol | BaO |
| 2 Mol | BaO₂ |
| 6 Mol | CuO |

Dies würde einer Verbindung mit der hypothetischen Zusammensetzung

YBa₂Cu₃O_{7,5}

entsprechen.

Die obige, in Bezug auf den Sauerstoffgehalt der anzustrebenden supraleitenden Verbindung überstöchiometrische Pulvermischung wurde einem reaktiven Glühprozess unter Sauerstoffatmosphäre bei einer Temperatur von 950 °C und einem Druck von 100 MPa (1000 bar) während 10 h unterworfen. Durch den Glühprozess wurde die supraleitende Verbindung in Form eines Suterkörpers gebildet. Der letztere wurde nun zunächst langsam auf ca. 500 °C und dann rasch auf Raumtemperatur abgekühlt, stets unter Beibehaltung des Druckes. Dann wurde er gemahlen und das fertige Pulver in die peripheren Löcher 10 abgefüllt.

Die mit einem Nickelmantel 11 und einer Kupferhülle versehene, mit den obigen Pulvern gefüllte Silberstange 8 wurde nun durch Kaliberwalzen in ihrem Querschnitt sukzessive auf etwa 1/16 des ursprünglichen Masses reduziert, wobei die Löcher noch einen Durchmesser von ca. 3 mm aufwiesen. Durch Ziehen wurde der Querschnitt des Werkstücks nochmals auf ca. 1/6 reduziert. Die ursprünglich 12 mm Durchmesser aufweisenden Löcher wiesen noch ein Mass von ca. 1,2 mm auf. Nun wurde das Werkstück unter einem äusseren Druck von 200 MPa (2000 bar) auf eine Temperatur von 600 °C gebracht und während 10 h unter diesen Bedingungen gehalten. Dabei sinterten die zuvor mehr oder weniger losen Pulverteilchen der supraleitenden Verbindung je zu einem kompakten, zusammenhängenden Strang (Filament) zusammen. Nach diesem Sinterprozess wurde der auf diese Weise hergestellte Mehrfach-Filamentleiter auf Raumtemperatur abgekühlt.

### Ausführungsbeispiel 6:

### Vergl. Fig. 7!

In einem zylindrischen Silberblock 8 von 100 mm Durchmesser als zusammenhängendem gemeinsamem Metallmantel wurden 7 Gruppen von je 7 achsenparallelen Löchern 9 von 6 mm Durchmesser gebohrt. Um je ein zentrales Loch 9 waren 6 weitere Löcher 10 pro Gruppe zentralsymmetrisch angeordnet, so dass deren Achsen ein gleichseitiges Sechseck bildeten. Der Achsenabstand der einer Gruppe angehörenden Löcher 10 betrug 7,5 mm. Der Silberblock wurde stramm in ein Nickelrohr 11 von 100 mm Innen- und 130 mm Aussendurchmesser (Wandstärke 15 mm) eingepasst.

Die zentralen Löcher 9 wurden mit der Sauerstoffabgebenden Substanz in Form einer Mischung von BaO₂- und BaO-Pulver gefüllt.

In die peripheren Löcher 10 wurde eine Pulvermischung aus den Komponenten des herzustellenden Supraleitermaterials eingefüllt. Letzteres sollte im Endzustand die Zusammensetzung

YBa₂Cu₃O₇₊ₓ, mit -0,5 ≦ x ≦ 0,1

aufweisen. Die Komponenten waren in folgendem Mengenverhältnis vorhanden:

| | |
|---|---|
| 1 Mol | Y₂O₃ |
| 3 Mol | BaO |
| 1 Mol | BaO₂ |
| 6 Mol | CuO |

Dies würde der folgenden stöchiometrischen Verbindung entsprechen:

YBa₂Cu₃O₇

Der mit einem Nickelmantel 11 versehene Silberblock 8 wurde nun in mehreren Arbeitsgängen durch Kaliberwalzen und Ziehen ähnlich Beispiel 5 derart verformt, dass der Enddurchmesser der Löcher 9, 10 noch ca. 0,8 mm betrug. Nun wurde das Werkstück einem reaktiven Glüh- und Sinterprozess bei einer Temperatur von 900 °C und einem äusseren Druck von 200 MPa (2000 bar) während 8 h unterworfen. Dabei setzten sich die oxydischen Komponenten chemisch um und bildeten die gewünschte supraleitende Verbindung. Gleichzeitig sinterten die Pulverteilchen zusammen und bildeten einen zusammenhängenden Strang innerhalb jeder der vom Silberkörper 8 (Gerfüst) gebildeten Röhren. Nach dem Glüh- und Sinterprozess wurde das Werkstück auf 500 °C abgekühlt und während 10 h bei dieser Temperatur und dem Druck von 200 MPa (2000 bar) gehalten. Dann wurde auf Raumtemperatur abgekühlt. Der in den zentralen Löchern 9 in der sauerstoffabgebenden Substanz vorhandene Sauerstoffüberschuss konnte durch den Silberkörper 8 hindurch in das in den peripheren Löchern 10 untergebrachte Supraleitermaterial diffundieren und dessen gewünschte Zusammensetzung gewährleisten. Es stand somit auch für den späteren Betrieb eine ausreichende Sauerstoffreserve zur Verfügung.

### Ausführungsbeispiel 7:

### Vergl. Fig. 7!

Es wurde zuerst eine Verbindung aus folgenden Komponenten in Pulverform hergestellt:

| | |
|---|---|
| 1 Mol | Y₂O₃ |
| 4 Mol | BaO |
| 6 Mol | CuO |

Die Pulvermischung wurde unter einem Sauerstoffdruck von 100 kPa (1 bar) während 10 h bei einer Temperatur von 950 °C einem reaktiven Glüh- und Sinterprozess unterworfen und anschliessend abgeschreckt. Die Zusammensetzung der Sinterkörper entsprach der Formel

YBa₂Cu₃O₇₊ₓ,

wobei im vorliegenden Fall x ≈ -0,6 betrug. Diese Verbindung ist an sich kein Supraleiter, da ihr der nötige Sauerstoffüberschuss fehlt. Es handelt sich um einen Stoff mit Halbleitereigenschaften. Der Sinterkörper wurde gemahlen und in periphere Löcher 10 eines Silberblocks 8 gemäss Beispiel 6 abgefüllt. In die zentralen Löcher 9 wurde als sauerstoffabgebende Substanz Pb₃O₄ in Pulverform eingefüllt. Der Silberblock 8 mit Nickelhülle 11 wurde gemäss Beispiel 6 verformt, indem er im Querschnitt stark reduziert wurde. Nun wurde das Ganze einer Glühbehandlung bei 800 °C unter einem äusseren Druck von 100 MPa (1000 bar) während 10 h unterworfen. Nun wurde langsam auf 500 °C abgekühlt und unter Druck während 40 h auf dieser Temperatur gehalten. Dann wurde rasch auf Raumtemperatur abgekühlt. Während dieser stufenweisen Wärmebehandlung nahm die komplexe Verbindung den nötigen Sauerstoff auf und wurde zum Supraleiter.

Die Erfindung ist nicht auf die Ausführungsbeispiele beschränkt. Die abschliessende Wärmebehandlung nach dem Warm- und/oder Kaltverformungsprozess durch Pressen, Walzen, Rundhämmern und Ziehen erfolgt grundsätzlich bei Temperaturen bis 950 °C.

Diese Wärmebehandlung kann auf verschiedene Weise erfolgen. Sie hat auf das thermodynamische Gleichgewicht der Reaktion BaO₂⇄BaO + ½O₂ bei ca. 700 °C Rücksicht zu nehmen. Demnach betragen die Sintertemperaturen (Reaktionstemperaturen) 600 bis 950 °C (vorzugsweise 700 bis 950 °C), die Reaktionszeiten (Haltezeiten) 0,1 bis 100 h (vorzugsweise 1 bis 10 h), wobei die anzuwendenden Drücke von den Reaktionstemperaturen und dem Aufbau des Drahtes (Material und Geometrie der Ummantelung etc.) abhängen. Zur Durchführung der Wärmebehandlung wird daher vorteilhafterweise eine Anlage zum heiss-isostatischen Pressen (Drucksintern) verwendet. Die Drücke betragen demzufolge 100 kPa - 1 GPa (10 bis 10000 bar), vorzugsweise 500 kPa - 200 MPa (50 bis 2000 bar).

Die Barium-Sauerstoff-Verbindung soll aus BaO₂ oder einer Mischung von BaO₂ und BaO bestehen. Es soll darauf hingewiesen werden, dass die Verwendung von BaO₂ anstelle des hygroskopischen BaO allgemein auch für die Herstellung von beliebigen Supraleiter-Körpern (andern als Drahtmaterial) Vorteile bietet. Gegenüber der Verwendung von BaCO₃ besteht der Vorteil des Entfallens des Kalzinierungsprozesses (Austreiben von CO₂). Die zwischen Kern 4 und Metallmantel 1 anzuordnende Zwischenschicht 2 aus Silber soll eine Dicke von 5 bis 30 % des Kerndurchmessers aufweisen. Dieser Verfahrensschritt kann durch Einsetzen eines Silberrohres, Aufspritzen von Silber oder galvanischem Aufbringen auf die Innenseite des Kupferrohres durchgeführt werden. Im Falle des direkten Kontaktes Ag/Cu wird zwischen 600 und 750 °C während 5-500 h gesintert (Vermeidung des Anschmelzens des Eutektikums Ag/Cu). Das gleiche gilt für mit CuO beschichtetes Kupferrohr. Die CuO-Schicht soll eine Dicke von 1 bis 100 µm aufweisen. Die Diffusionssperre 6 besteht vorzugsweise aus Ni, Ta, Nb, V oder einer Legierung mindestens zweier dieser Elemente mit einer Dicke von 2 bis 20 % des Kerndurchmessers. Gesintert wird bei 700 bis 950 °C während 1 bis 25 h. Die Zwischenschicht 2 aus Silber kann mit einem bei höherer Temperatur Sauerstoff abgebenden Sauerstoffträger in Form eines Oxids ausgewählt aus den Verbindungen AgO und BaO₂ in einer Menge bis zu 90 M % dotiert sein.

Das Verhältnis BaO zu BaO₂ wird so eingestellt, dass unter den gegebenen Sinterbedingungen gerade soviel Sauerstoff aus dem Kern 4 durch die umgebende Zwischenschicht 2 aus Silber (unvermeidlich) wegdiffundiert, dass am Ende die supraleitende Verbindung YBa₂Cu₃O_{6,5 + y} mit einem in Bezug auf die supraleitenden Eigenschaften optimalen y-Wert zwischen 0<y<1 zurückbleibt. Der wegdiffundierte Sauerstoff wird sich im wesentlichen im Fall der Ausführungsbeispiele 1, 2 und 4 als Oxydhaut auf der Innenseite des Metallmantels 1 und im Fall des Ausführungsbeispiels 3 auf der Innenseite der Diffusionssperre 6 als Oxid der Elemente Ni, Ta, Nb, V ablagern.

Nach einer ersten Variante wird das Verfahren so durchgeführt, dass die noch nicht miteinander reagierten pulverförmigen Ausgangsstoffe seltenes Erdmetalloxid, Barium-Sauerstoff-Verbindung und Kupferoxid CuO unmittelbar zur Erzeugung des Kerns 4 verwendet und in das Metallrohr 1 abgefüllt werden. Letzteres besteht vorzugsweise aus Kupfer und umschliesst den Kern 4 als allseitiger Mantel. Vor dem Abfüllen wird zwischen Kern 4 und Mantel eine Zwischenschicht 2 aus Silber aufgebracht, welche eine Dicke von 5 bis 30 % des Kerndurchmessers aufweist. Die Wärmebehandlung wird bei einer Temperatur bis 950 °C während mindestens 0,1 h durchgeführt, wobei die Ausgangsstoffe des Kerns 4 miteinander unter Bildung einer supraleitenden Verbindung reagieren und gesintert werden. Die Erwärmung bei Sintertemperatur erfolgt im Zeitraum von mindestens 1 h, die Abkühlung bis auf 200 °C herunter mit einer Geschwindigkeit von 10 bis 100 K/h.

Nach einer zweiten Variante wird das Verfahren so durchgeführt, dass die pulverförmigen Ausgangsstoffe seltenes Erdmetalloxid, Barium-Sauerstoff-Verbindung und Kupferoxid CuO nach dem Mischen zunächst einem reaktiven Glühprozess unter einem Sauerstoffdruck während 1 bis 100 h unterworfen wurden. Der dabei gebildete Sinterkörper wird auf eine Partikelgrösse von höchstens 5 µm gemahlen und das Supraleiterpulver in den den Metallmantel 1 bildenden Körper abgefüllt. Nun wird der auf diese Art erzeugte Verbundkörper verformt und unter einem äusseren Druck von 100 kPa - 300 MPa (10 bis 3000 bar) bei einer Temperatur von 500 bis 900 °C dicht gesintert.

Zur Herstellung eines Mehrfach-Filamentleiters werden in einem von einer Nickelhülle 11 allseitig umschlossenen, als Gerüst dienenden Silberkörper 8 mehrere Gruppen von Löchern 9, 10 angeordnet. Jede Gruppe hat ein zentrales Loch 9, welches mit einer sauerstoffabgebenden Substanz gefüllt wird. Letztere besteht aus BaO₂ oder einer Mischung von BaO₂ und BaO oder aus MnO₂ oder einer Mischung von MnO₂ und Mn₂O₃ oder aus Pb₃O₄ oder einer Mischung von Pb₃O₄ und PbO. Um das zentrale Loch 9 sind weitere Löcher 10 rundherum angeordnet, in welche eine Mischung pulverförmiger Ausgangsstoffe (seltenes Erdmetalloxid, Barium-Sauerstoff-Verbindung, CuO) in annähernd stöchiometrischem Verhältnis oder fertiges, zuvor durch reaktives Glühen hergestelltes Supraleiterpulver eingefüllt wird. Nun wird das Ganze durch Kaliberwalzen und Ziehen auf einen höchstens 2 % ausmachenden Querschnitt reduziert. Zum Schluss wird unter einem Druck von mindestens 100 kPa (10 bar) bei einer Temperatur von 500 bis 900 °C während mindestens 1 h geglüht, wobei die von Ausgangsstoffen oder Supraleiterpulver gebildeten Filamente zu einem monolithischen kompakten Supraleiterkörper zusammengesintert werden. Selbstverständlich kann die Anordnung der Löcher 9 und 10 und deren Funktion als Raumbegrenzung für Supraleiterpulver bzw. sauerstoffabgebende Substanz auch eine beliebig andere sein.

Der Hauptvorteil der Erfindung besteht darin, dass nicht alle Operationen bei der Herstellung des Supraleiters unter äusserem Sauerstoffdruck durchgeführt werden müssen und dass wenigstens teilweise auf für Sauerstoff durchlässige Stoffe (Silber) als Mantelmaterialien mit ihren langen Diffusionswegen verzichtet werden kann. Der für die supraleitenden Eigenschaften des Werkstoffs massgebende, für die Ueberstöchiometrie charakteristische Sauerstoffpartialdruck wird primär in situ durch die Verwendung von sauerstoffabgebenden Substanzen bereitgestellt.

## Patentansprüche

1. Verfahren zur Herstellung eines ummantelten Drahtes oder eines Mehrfach-Filamentleiters
a) aus einem keramischen Hochtemperatur-Supraleiter auf der Basis eines keramischen Stoffes des Typs SEBa₂Cu₃O_{6,5+y}, wobei SE ein seltenes Erdmetall bedeutet, y gemäss 0 < y < 1 auf Werte zwischen 0 und 1 beschränkt ist und
b) der Hochtemperatur-Supraleiter als Kern (3, 4, 10) in einem als mechanischer Träger und Notstromleiter dienenden Metallmantel bzw. Metallrohr (1, 11) angeordnet ist,
c) wobei ein Pulver zur Bildung des gewünschten Hochtemperatur-Supraleiters in das Innere des Metallrohres (1, 11) eingebracht und
d) danach das so aufgefüllte Metallrohr (1, 11) durch eine Kalt- und/oder Warmverformung in seinem Querschnitt verringert bzw. zu einem Draht gestreckt und
e) anschliessend einer Wärmebehandlung unterzogen wird,
dadurch gekennzeichnet,
f) dass dieses Pulver eine Pulvermischung der Hochtemperatur-Supraleiter-Ausgangsoxide, nämlich ein seltenes Erdmetalloxid, Kupferoxid CuO und BaO₂ oder eine Mischung aus BaO₂ und BaO in einem solchen Ausmass enthält, dass gegenüber der stöchiometrischen Verbindung SEBa₂Cu₃O_{6,5+y} ein Sauerstoffüberschuss vorhanden ist und daß diese Ausgangsstoffe bei der Wärmebehandlung miteinander unter Bildung einer supraleitendem Verbindung reagieren und gesintert werden.

2. Verfahren zur Herstellung eines ummantelten Drahtes oder eines Mehrfach-Filamentleiters
a) aus einem keramischen Hochtemperatur-Supraleiter auf der Basis eines keramischen Stoffes des Typs SEBa₂Cu₃O_{6,5+y,} wobei SE ein seltenes Erdmetall bedeutet, y gemäss 0 < y < 1 auf Werte zwischen 0 und 1 beschränkt ist und
b) der Hochtemperatur-Supraleiter als Kern (3, 4, 10) in einem als mechanischer Träger und Notstromleiter dienenden Metallmantel bzw. Metallrohr (1, 11) angeordnet ist,
c) wobei ein Pulver zur Bildung des gewünschten Hochtemperatur-Supraleiters in das Innere des Metallrohres (1, 11) eingebracht und
d) danach das so aufgefüllte Metallrohr (1, 11) durch eine Kalt- und/oder Warmverformung in seinem Querschnitt verringert bzw. zu einem Draht gestreckt und
e) anschliessend einer Wärmebehandlung unterzogen wird, fertiges Hochtemperatur-Supraleitermaterial
dadurch gekennzeichnet,
f) dass dieses Pulver fertiges Hochtemperatur-Supraleitermaterial mit der Zusammensetzung SEBa₂Cu₃O_{6,5+y} und BaO₂ oder eine Mischung aus BaO₂ und BaO in einem solchen Ausmass enthält, dass gegenüber der stöchiometrischen Verbindung SEBa₂Cu₃O_{6,5+y} ein Sauerstoffüberschuss vorhanden ist.

3. Verfahren nach Anspruch 1 oder 2, dadurch gekennzeichnet,
a) dass das Metallrohr (1) aus Kupfer besteht,
b) dass zwischen dem Metallrohr (1) und dem Kern (3, 4)
c) vor dem Einbringen des Pulvers in das Metallrohr (1) eine zwischenschicht (2) aus Silber aufgebracht oder angeordnet wird,
d) dass die Wärmebehandlung eine mindestens 0,1 h dauernde Erhitzung bei einer Sintertemperatur von ≦ 950 °C umfasst,
e) wobei die Erwärmung bis auf Sintertemperatur mindestens 1 h dauert und
f) die Abkühlung von Sintertemperatur auf 200 °C mit einer Abkühlgeschwindigkeit im Bereich von 10 K/h - 100 K/h erfolgt.

4. Verfahren nach Anspruch 3, dadurch gekennzeichnet,
a) dass das Aufbringen oder Anordnen der Zwischenschicht (2) durch Einsetzen eines Silberrohres oder
b) durch Aufspritzen von Silber auf die Innenseite des Kupferrohres (1) oder
C) durch galvanisches Aufbringen von Silber auf die Innenseite des Kupferrohres (1) erfolgt.

5. Verfahren nach Anspruch 3 oder 4, dadurch gekennzeichnet,
a) dass die Sintertemperatur in einem Temperaturbereich zwischen 600 °C und 750 °C liegt und
b) dass während einer Dauer im Bereich von 50 h bis 500 h gesintert wird.

6. Verfahren nach einem der Ansprüche 3 bis 5, dadurch gekennzeichnet, dass das Kupferrohr (1) vor dem Einbringen des Pulvers in dessen Innenraum auf seiner Innenseite so stark oxydiert wird, dass eine sich bildende Schicht (5) aus Kupferoxid CuO eine Dicke im Bereich von 1 µm bis 100 µm aufweist.

7. Verfahren nach Anspruch 3 oder 4, dadurch gekennzeichnet,
a) dass zwischen die Zwischenschicht (2) aus Silber und das Metallrohr (1) eine Diffusionssperre (6) aus Nickel oder
b) Tantal oder
c) Niob oder
d) Vanadium oder
e) einer Legierung mindestens 2er dieser Elemente eingebracht wird,
f) dass die Sintertemperatur in einem Temperaturbereich zwischen 700 °C und 950 °C liegt und
g) dass während einer Dauer im Bereich von 1 h bis 25 h gesintert wird.

8. Verfahren nach einem der Ansprüche 2 bis 7, dadurch gekennzeichnet, dass die Zwischenschicht (2) aus Silber mit einem bei höheren Temperaturen elementaren Sauerstoff abgebenden Sauerstoffträger in Form eines Oxids, ausgewählt aus den Verbindungen AgO und BaO₂, in einer Menge bis zu 10 M % dotiert wird.

9. Verfahren nach Anspruch 3, dadurch gekennzeichnet,
a) dass die Wärmebehandlung bei einer Temperatur im Bereich von 600 °C bis 950 °C
b) während einer Dauer im Bereich von 0,1 h - 100 h
c) unter einem allseitigen Druck im Bereich von 1 MPa (10 bar) - 1 GPa (10000 bar) durchgeführt wird,
d) insbesondere, dass die Wärmebehandlung bei einer Temperatur im Bereich von 700 °C bis 950 °C
e) während einer Dauer im Bereich von 1 h - 10 h
c) unter einem allseitigen Druck im Bereich von 5 MPa (50 bar) - 200 MPa (2000 bar) durchgeführt wird.

10. Verfahren nach Anspruch 2, dadurch gekennzeichnet,
a) dass das Pulver des fertigen Hochtemperatur-Supraleitermaterials mit der Zusammensetzung SEBa₂Cu₃O_{6,5+y} aus einer Pulvermischung der Hochtemperatur-Supraleiter-Ausgangsoxide, nämlich ein seltenes Erdmetalloxid, mindestens eine Barium-Sauerstoffverbindung und Kupferoxid CuO, in einem annähernd stöchiometrischen Verhältnis des zu bildenden Hochtemperatur-Supraleiters durch einen reaktiven Glühprozess
b) unter einem Sauerstoffdruck im Bereich von 1 MPa (10 bar) - 300 MPa (3000 bar)
c) bei einer Temperatur im Bereich von 600 °C - 950 °
d) während einer Dauer im Bereich von 1 h - 100 h hergestellt wird,
e) dass der dabei gebildete Sinterkörper mit der Zusammensetzung SEBa₂Cu₃O_{6,5+y} auf eine Partikelgrösse von höchstens 5 µm gemahlen wird und
f) dass die Wärmebehandlung nach der Kalt- und/oder Warmverformung des Metallrohres (1) unter einem äusseren Druck im Bereich von 1 MPa (10 bar) - 300 MPa (3000 bar)
g) bei einer Sintertemperatur im Bereich von 500 °C - 900 °C durchgefürt wird.

11. Verfahren nach Anspruch 1 oder 2, dadurch gekennzeichnet,
a) dass zur Herstellung eines Mehrfach-Filamentleiters in einem ein Gerüst bildenden Silberkörper (8), der mit einer Nickelhülle (11) versehen ist, mindestens eine Gruppe von Löchern (9, 10) angeordnet wird,
b) derart, dass um je ein zentrales Loch (9) je Gruppe weitere periphere Löcher (10) rundherum angeordnet sind,
c) dass in mindestens eines der zentralen Löcher (9) eine sauerstoffabgebende Substanz eingefüllt wird, deren Sauerstoff-Sättigungsdampfdruck im Temperaturbereich von 400 °C - 950 °C mindestens 100 Pa (0,001 bar) und höchstens 200 MPa (2000 bar) beträgt,
d) dass in die peripheren Löcher (10) das Pulver zur Herstellung des Hochtemperatur-Supraleiters eingefüllt wird und
e) dass die Wärmebehandlung ein Glühen bzw. Sintern unter einem Druck von mindestens 1 MPa (10 bar)
f) bei einer Glüh- bzw. Sintertemperatur im Bereich von 500 °C - 900 °C
g) während mindestens 1 h umfasst, wodurch sich ein monolithischer, kompakter Supraleiterkörper bildet.

12. Verfahren nach Anspruch 11, dadurch gekennzeichnet, dass die sauerstoffabgebende Substanz BaO₂ oder eine Mischung von BaO₂ und BaO oder MnO₂ oder eine Mischung von MnO₂ und Mn₂O₃ oder Pb₃O₄ oder eine Mischung von Pb₃O₄ und PbO ist.

## Claims

1. Method of producing a sheathed wire or multi-filament conductor
a) from a ceramic high-temperature superconductor based on a ceramic substance of the type REBa₂Cu₃O_{6,5+y}, where RE denotes a rare-earth metal, y being limited to values between 0 and 1 in accordance with 0 < y < 1, and
b) the high-temperature superconductor is provided as core (3, 4, 10) in a metal sheath or metal tube (1, 11) which serves as mechanical support and emergency power conductor,
c) in which method a powder is introduced into the interior of the metal tube (1, 11) to form the desired high-temperature superconductor and
d) the metal tube (1, 11) filled in this way then being reduced in its cross section or drawn to form a wire by a cold and/or hot deformation, and
e) then being subjected to a heat treatment, characterized
f) in that said powder contains a powder mixture of the high-temperature superconductor starting oxides, namely a rare-earth metal oxide, copper oxide CuO and BaO₂ or a mixture of BaO₂ and BaO in such a proportion that an oxygen excess is present compared with the stoichiometric compound REBa₂Cu₃O_{6,5+y}, and in that said starting substances react during the heat treatment with one another to form a superconducting compound and are sintered.

2. Method of producing a sheathed wire or a multi-filament conductor
a) from a ceramic high-temperature superconductor based on a ceramic substance of the type REBa₂Cu₃O_{6,5+y}, where RE denotes a rare-earth metal, y being limited to values between 0 and 1 in accordance with 0 < y < 1, and
b) the high-temperature superconductor is provided as core (3, 4, 10) in a metal sheath or metal tube (1, 11) which serves as mechanical support and emergency power conductor,
c) a powder being introduced into the interior of the metal tube (1, 11) to form the desired high-temperature superconductor, and
d) the metal tube filled in this way then being reduced in its cross section or drawn to form a wire by a cold and/or hot deformation, and
e) then being subjected to a heat treatment, characterized
f) in that said powder contains final high-temperature superconductor material having the composition REBa₂CU₃O_{6,5+y} and BaO₂ or a mixture of BaO₂ and BaO in such a proportion that an oxygen excess is present compared with the stoichiometric compound REBa₂Cu₃O_{6,5+y}.

3. Method according to Claim 1 or 2, characterized
a) in that the metal tube (1) is composed of copper,
b) in that, between the metal tube (1) and the core (3, 4),
c) a silver interlayer (2) is applied or provided before the introduction of the powder into the metal tube (1), and
d) in that the heat treatment comprises a heating lasting at least 0.1 h at a sintering temperature of ≦ 950°C,
e) the heating to sintering temperature lasting at least 1 h and
f) the cooling from sintering temperature to 200°C takes place with a cooling rate in the range of 10 K/h-100 K/h.

4. Method according to Claim 3, characterized
a) in that the application or provision of the inter-layer (2) is carried out by inserting a silver tube, or
b) by spraying silver onto the inside of the copper tube (1), or
c) by electrodeposition of silver on the inside of the copper tube (1).

5. Method according to Claim 3 or 4, characterized
a) in that the sintering temperature is in a temperature range between 600°C and 750°C, and
b) in that sintering is carried out for a time in the range from 50 h to 500 h.

6. Method according to one of Claims 3 to 5, characterized in that the copper tube (1) is oxidized on its inside before the introduction of the powder into its interior to such an extent that a layer (5) of copper oxide CuO which forms has a thickness in the range from 1 µm to 100 µm.

7. Method according to Claim 3 or 4, characterized
a) in that there is introduced, between the silver inter layer (2) and the metal tube (1) a diffusion barrier (6) composed of nickel or
b) tantalum or
c) niobium or
d) vanadium or
e) an alloy of at least two of said elements,
f) in that the sintering temperature is in a temperature range between 700°C and 950°C and
g) in that sintering is carried out for a time in the range from 1 h to 25 h.

8. Method according to one of Claims 2 to 7, characterized in that the silver interlayer (2) is doped with an oxygen carrier which releases elemental oxygen at fairly high temperatures and is in the form of an oxide selected from the compounds AgO and BaO₂ in an amount of up to 10 M%.

9. Method according to Claim 3, characterized
a) in that the heat treatment is carried out at a temperature in the range from 600°C to 950°C
b) for a time in the range of 0.1 h-100 h
c) under an all-round pressure in the range of 1 MPa (10 bar) - 1 GPa (10000 bar), and
d) in particular, in that the heat treatment is carried out at a temperature in the range from 700°C to 950°C
e) for a time in the range from 1 h-10 h
f) under an all-round pressure in the range from 5 MPa (50 bar) - 200 MPa (2000 bar).

10. Method according to Claim 2, characterized
a) in that the powder of the finished high-temperature superconductor material having the composition REBa₂Cu₃O_{6,5+y} is produced from a powder mixture of the high-temperature superconductor starting oxides, namely a rare-earth metal oxide, at least one barium/oxygen compound and copper oxide CuO, in an approximately stoichiometric ratio of the high-temperature superconductor to be formed, by an reactive annealing process
b) under an oxygen pressure in the range of 1 MPa (10 bar) - 300 MPa (3000 bar)
c) at a temperature in the range of 600°C-950°C
d) for a time in the range of 1 h-100 h,
e) in that the sintered body formed in this process and having the composition REBa₂Cu₃O_{6,5+y} is ground to a particle size of not more than 5 µm, and
f) in that the heat treatment after the cold and/or hot deformation of the metal tube (1) is carried out under an external pressure in the range of 1 MPa (10 bar) - 300 MPa (3000 bar)
g) at the sintering temperature in the range of 500°C-900°C.

11. Method according to Claim 1 or 2, characterized
a) in that, to produce a multi-filament conductor in a silver body (8) which forms a matrix and which is provided with a nickel casing (11), at least one group of holes (9, 10) is provided
b) in such a way that further peripheral holes (10) are provided around one central hole (9) in each case in each group,
c) in that, in at least one of the central holes (9), an oxygen-releasing substance is introduced whose oxygen saturation vapour pressure in the temperature range 400°C-950°C is at least 100 Pa (0.001 bar) and not more than 200 MPa (2000 bar),
d) in that the powder for producing the high-temperature superconductor is poured into the peripheral holes (10), and
e) in that the heat treatment comprises an annealing or sintering under a pressure of at least 1 MPa (10 bar)
f) at an annealing or sintering temperature in the range of 500°C-900°C
g) for at least 1 h, as a result of which a monolithic compact superconductor body is formed.

12. Method according to Claim 11, characterized in that the oxygen-releasing substance is BaO₂, or a mixture of BaO₂ and BaO or MnO₂ or a mixture of MnO₂ and Mn₂O₃ or Pb₃O₄ or a mixture of Pb₃O₄ and PbO.

## Revendications

1. Procédé pour la fabrication d'un fil enrobé ou d'un conducteur à filaments multiples
a) constitué par un supraconducteur céramique à haute température, sur la base d'une substance céramique de type SEBa₂Cu₃O_{6,5 + y}, dans laquelle SE représente un métal de terre rare et y, conformément à 0<y<1, est limité à des valeurs entre 0 et 1 et
b) le supraconducteur à haute température est placé en tant que coeur (3, 4, 10) dans une gaine métallique ou éventuellement un tube métallique (1, 11) qui sert de support mécanique et de conducteur auxiliaire,
c) dans lequel on introduit une poudre pour la formation du supraconducteur à haute température souhaité à l'intérieur du tube métallique (1, 11) et
d) ensuite le tube métallique (1, 11) ainsi rempli est rétréci au moyen d'un processus de matriçage à chaud et/ou à froid, dans sa section transversale ou est éventuellement étiré en un fil et
e) pour finir est soumis à un traitement thermique,
caractérisé en ce que,
f) cette poudre contient un mélange de poudres des oxydes de base du supraconducteur à haute température, précisément un oxyde de métal de terre rare, un oxyde de cuivre CuO et du BaO₂ ou un mélange de BaO₂ et de BaO dans une proportion telle qu'iil y a un excédent d'oxygène par rapport au composé stoechiométrique SEBa₂Cu₃O_{6,5 + y} et ces constituants de base sont mis en réaction les uns avec les autres au moyen d'un traitement thermique et sont frittés pour la formation d'un composé supraconducteur.

2. Procédé pour la fabrication d'un fil enrobé ou d'un conducteur à filaments multiples
a) constitué par un supraconducteur céramique à haute température, sur la base d'une substance céramique de type SEBa₂Cu₃O_{6,5 + y}, dans laquelle SE représente un métal de terre rare et y, conformément à 0<y<1, est limité à des valeurs entre 0 et 1 et
b) le supraconducteur à haute température est placé en tant que coeur (3, 4, 10) dans une gaine métallique ou éventuellement un tube métallique (1, 11) qui sert de support mécanique et de conducteur auxiliaire,
c) dans lequel l'on introduit une poudre pour la formation du supraconducteur à haute température souhaité à l'intérieur du tube métallique (1, 11) et
d) ensuite le tube métallique (1, 11) ainsi rempli est rétréci au moyen d'un processus de matriçage à chaud et/ou à froid, dans sa section transversale ou éventuellement est étiré en un fil et
e) pour finir est soumis à un traitement thermique,
caractérisé en ce que,
f) cette poudre contient du matériau supraconducteur à haute température préparé avec la composition SEBa₂Cu₃O_{6,5+y} et du BaO₂ ou un mélange de BaO₂ et BaO dans une proportion telle qu'il y a un excédent d'oxygène par rapport au composé stoechiométrique SEBa₂Cu₃O_{6,5+y}.

3. Procédé selon la revendication 1 ou 2, caractérisé en ce que,
a) le tube métallique (1) est en cuivre,
b) entre le tube métallique (1) et le coeur (3, 4)
c) avant l'introduction de la poudre dans le tube métallique (1), on applique ou dispose une couche intermédiaire (2) en argent,
d) le traitement thermique comprend un chauffage durant au moins 0,1 h à une température de frittage ≦ 950 °C,
e) l'augmentation de la température jusqu'à la température de frittage durant au moins 1 h et
f) le refroidissement de la température de frittage jusqu'à 200 °C est réalisé avec une vitesse de refroidissement de l'ordre de 10 K/h - 100 K/h.

4. Procédé selon la revendication 3, caractérisé en ce que
a) l'application ou la disposition de la couche intermédiaire (2) est réalisée en insérant un tube d'argent ou
b) en déposant de l'argent par pulvérisation sur la paroi interne du tube de cuivre (1) ou
c) par galvanisation d'argent sur la paroi interne du tube de cuivre (1).

5. Procédé selon la revendication 3 ou 4, caractérisé en ce que
a) la température de frittage se situe dans un domaine de température entre 600 °C et 750 °C et
b) le frittage est effectué pendant une durée de l'ordre de 50 h jusqu'à 500 h.

6. Procédé selon l'une quelconque des revendications 3 à 5, caractérisé en ce que le tube de cuivre (1), avant l'introduction de la poudre dans son espace interne, est oxydé sur sa paroi interne si fortement qu'il se forme une couche d'oxyde de cuivre CuO (5) présentant une épaisseur de l'ordre de 1 µm à 100 µm.

7. Procédé selon la revendication 3 ou 4, caractérisé en ce que
a) entre la couche intermédiaire (2) en argent et le tube métallique (1), on place une barrière de diffusion (6) en nickel ou
b) en tantale ou
c) en niobium ou
d) en vanadium ou
e) en un alliage d'au moins deux de ces éléments,
f)la température de frittage se situe dans un domaine de température entre 700 °C et 950 °C et
b) le frittage est effectué pendant une durée de l'ordre de 1 h jusqu'à 25 h.

8. Procédé selon l'une quelconque des revendications 2 à 7, caractérisé en ce que la couche intermédiaire (2) en argent est dopée d'un comburant cédant de l'oxygène élémentaire à assez haute température sous la forme d'un oxyde choisi parmi les composés AgO et BaO₂ dans une quantité allant jusqu'à 10 % molaire.

9. Procédé selon la revendication 3, caractérisé en ce que
a) la traitement thermique est réalisé à une température de l'ordre de 600 °C à 950 °C
b) pendant une durée de l'ordre de 0,1 h - 100 h
c) sous une pression de tous côtés de l'ordre de 1 MPa (10 bar)- 1 GPa (10000 bar),
d) en particulier en ce que le traitement thermique est réalisé à une température de l'ordre de 700 °C à 950 °C
b) pendant une durée de l'ordre de 1 h - 10 h
c) sous une pression de tous côtés de l'ordre de 5 MPa (50 bar) - 200 MPa (2000 bar).

10. Procédé selon la revendication 2, caractérisé en ce que
a) on produit la poudre du matériau supraconducteur à haute température tout prêt, avec la composition SEBa₂Cu₃O_{6,5 + y} issue d'un mélange de poudreasd'oxydes de base d'un supraconducteur à haute température, précisément un oxyde de métal de terre rare, au moins un composé baryum-oxygène et un oxyde de cuivre CuO, dans un rapport approximativement stoechiométrique du supraconducteur à haute température qui sera formé au moyen d'un chauffage réactionnel au rouge
b) sous une pression d'oxygène de l'ordre de 1 MPa (10 bar) - 30 MPa (3000 bar)
c) à une température de l'ordre de 600 °C à 950 °C
d) pendant une durée de l'ordre de 1 h - 100 h
e) le corps fritté ainsi formé avec la composition SEBa₂Cu₃O_{6,5 + y} est broyé pour obtenir une granulométrie d'un maximum de 5 µm
f) le traitement thermique après le processus de matriçage à chaud et/ou à froid du tube métallique (1) est réalisé sous une pression extérieure de l'ordre de 1 MPa (10 bar) - 300 MPa (3000 bar),
g) à une température de frittage de l'ordre de 500 °C - 900 °C.

11. Procédé selon la revendication 1 ou 2, caractérisé en ce que
a) pour la fabrication d'un conducteur à filaments multiples on dispose au moins un groupe de trous (9, 10) dans un corps en argent (8) servant d'ossature et pourvu d'une enveloppe en nickel (11),
b) de sorte qu'autour de chaque trou central (9) on a disposé en rond chaque fois d'autres trous périphériques (10)
c) dans au moins un des trous centraux (9), on verse une substance cédant de l'oxygène, dont la pression de vapeur saturée en oxygène à une température de l'ordre de 400 °C - 950 °C s'élève à au moins 100 Pa (0,001 bar) et au plus 200 MPa (2000 bar),
d) les trous périphériques (10) sont remplie de la poudre destinée à la fabrication du supraconducteur à haute température et
e) le traitement thermique comprend un chauffage au rouge ou, selon le cas, un frittage sous une pression d'au moins 1 MPa (10 bar)
f) à une température de chauffage au rouge ou, selon le cas, de frittage, de l'ordre de 500 °C - 900 °C
g) pendant au moins 1 h, donnant la formation d'un corps supraconducteur compact monolithique.

12. Procédé selon la revendication 11, caractérisé en ce que la substance cédant de l'oxygène est du BaO₂ ou un mélange de BaO₂ et de BaO ou du MnO₂ ou un mélange de MnO₂ et de Mn₂O₃ ou du Pb₃O₄ ou un mélange de Pb₃O₄ et de PbO.
